(19) **Europäisches Patentamt / European Patent Office / Office européen des brevets**

(11) **EP 2 950 111 B1**

(12) # FASCICULE DE BREVET EUROPEEN

(45) Date de publication et mention
de la délivrance du brevet:
**07.06.2017  Bulletin 2017/23**

(51) Int Cl.:
**G01R 21/133** *(2006.01)*  **G01R 22/10** *(2006.01)*
**G01R 31/04** *(2006.01)*

(21) Numéro de dépôt: **15164066.1**

(22) Date de dépôt: **17.04.2015**

(54) **PROCÉDÉ DE DÉTECTION D'ABSENCE DE CONNEXION D'UN COMPTEUR ÉLECTRIQUE POLYPHASÉ AU NEUTRE**

VERFAHREN ZUR ERKENNUNG DER ABWESENHEIT EINER VERBINDUNG ZWISCHEN EINEM MEHRPHASIGEN ELEKTRISCHEN ZÄHLER UND EINEM NULLLEITER

METHOD FOR DETECTING THE ABSENCE OF CONNECTION OF A POLYPHASE ELECTRICITY METER TO NEUTRAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **24.04.2014  FR 1453695**

(43) Date de publication de la demande:
**02.12.2015  Bulletin 2015/49**

(73) Titulaire: **SAGEMCOM ENERGY & TELECOM SAS 92500 Rueil-Malmaison (FR)**

(72) Inventeurs:
- **Teboulle, Henri**
  **92500 Rueil-Malmaison (FR)**
- **Hergault, Stéphane**
  **92500 Rueil-Malmaison (FR)**

(74) Mandataire: **Le Guen-Maillet**
**5, place de Newquay**
**BP 70250**
**35802 Dinard Cedex (FR)**

(56) Documents cités:
**EP-A1- 2 366 975      WO-A1-96/24070**
**WO-A1-2013/060382    FR-A1- 2 947 055**
**US-A- 5 854 995       US-A1- 2002 074 990**
**US-A1- 2008 097 707   US-A1- 2012 089 354**
**US-B1- 6 236 197**

- **ANGELO HAFNER ET AL: "An Electric Energy Quality Meter Using Hardware Reconfigurable Computing", 2006 1ST IEEE CONFERENCE ON INDUSTRIAL ELECTRONICS AND APPLICATIONS : SINGAPORE, 24 - 26 MAY 2006, PISCATAWAY, NJ : IEEE SERVICE CENTER, US, 1 mai 2006 (2006-05-01), pages 1-6, XP031026662, ISBN: 978-0-7803-9513-8**

**Description**

La présente invention concerne une détection d'absence de connexion d'un compteur électrique polyphasé doté de moyens de communication par courants porteurs en ligne à un fil de neutre d'un réseau d'alimentation électrique.

Il est connu des compteurs électriques effectuant des opérations de comptage d'énergie électrique consommée par des installations électriques que lesdits compteurs électriques sont en charge de superviser. Il existe notamment des compteurs électriques polyphasés, c'est-à-dire qui effectuent de telles opérations de comptage dans le cadre d'installations électriques alimentées par plusieurs phases dudit réseau d'alimentation électrique.Le document US 6,236,197 B1 divulgue un procédé de détection d'absence de connexion d'un compteur électrique polyphasé à un neutre d'un réseau d'alimentation électrique, le compteur étant connecté à une pluralité de phases du réseau et injectant dans le réseau des signaux par courants porteurs en ligne via une phase d'injection parmi ladite pluralité, une impédance de capacité prédéfinie existant entre chaque phase et le neutre.

On peut noter que, de nos jours, de tels compteurs électriques sont dotés de moyens de communication par courants porteurs en ligne PLT (« PowerLine Transmission » en anglais) permettant auxdits compteurs électriques de communiquer avec un concentrateur de données DC (« Data Concentrator » en anglais) dans un cadre de gestion avancée de comptage AMM (« Advanced Metering Management » en anglais).

Une anomalie pouvant se produire est qu'un compteur électrique polyphasé ne soit pas connecté au neutre du réseau d'alimentation électrique, ce qui pose des problèmes de sécurité et fausse les opérations de comptage. Il est donc souhaitable de pouvoir détecter de telles situations.

Il est aussi souhaitable de maintenir une bonne précision de comptage, que le compteur électrique polyphasé soit ou pas connecté au neutre du réseau d'alimentation électrique.

Il est aussi souhaitable de fournir une solution qui soit simple à mettre en oeuvre et à faible coût.

L'invention concerne un procédé de détection d'absence de connexion d'un compteur électrique polyphasé à un neutre d'un réseau d'alimentation électrique, le compteur électrique polyphasé étant connecté à une pluralité de phases du réseau d'alimentation électrique, le compteur électrique polyphasé injectant dans le réseau d'alimentation électrique des signaux par courants porteurs en ligne via une phase d'injection parmi ladite pluralité, une impédance de capacité prédéfinie existant entre chaque phase et le neutre. Le procédé est tel que le compteur électrique polyphasé effectue les étapes suivantes : obtenir des mesures de tension efficace entre chaque phase et un point de connexion destiné à connecter le compteur électrique polyphasé au neutre; calculer un indice R représentatif d'un rapport entre la tension efficace mesurée pour la phase d'injection et une somme des tensions efficaces mesurées pour les autres phases de ladite pluralité; comparer l'indice R avec des premier et second seuils, le premier seuil étant défini sur la base de la valeur minimale théorique de l'indice R et le second seuil étant défini sur la base de la valeur maximale théorique de l'indice R, au vu de tolérances de précision desdites capacités d'impédance et de tolérances de précision de tensions efficaces fournies par le réseau d'alimentation électrique via lesdites phases, lorsque le compteur électrique polyphasé n'est pas connecté au neutre; comparer la valeur de tension efficace mesurée sur chaque phase autre que la phase d'injection avec des troisième et quatrième seuils, le troisième seuil étant défini sur la base de la valeur minimale théorique de tension efficace et le quatrième seuil étant défini sur la base de la valeur maximale théorique de tension efficace, au vu desdites tolérances de précision, lorsque le compteur électrique polyphasé n'est pas connecté au neutre; et détecter que le compteur électrique n'est pas connecté au neutre lorsque les conditions suivantes sont remplies : l'indice R est supérieur ou égal au premier seuil et est inférieur ou égal au second seuil; et la valeur de tension efficace mesurée sur chaque phase à laquelle est connecté le compteur électrique polyphasé autre que la phase d'injection est supérieure ou égale au troisième seuil et est inférieure ou égale au quatrième seuil. Ainsi, le fait que le compteur électrique polyphasé ne soit pas connecté au neutre du réseau d'alimentation peut être détecté. Par exemple, cela permet d'activer une alarme correspondante.

Selon un mode de réalisation particulier, le compteur électrique polyphasé effectue une intégration de l'indice R sur une période temporelle de durée prédéfinie. Ainsi, la valeur de l'indice R est plus fiable.

Selon un mode de réalisation particulier, le premier seuil est défini en considérant : la valeur minimale de la capacité d'impédance entre la phase d'injection et le point de connexion au neutre ; la valeur maximale de la capacité d'impédance entre chaque phase autre que la phase d'injection et le point de connexion au neutre; la valeur maximale de la tension efficace fournie par le réseau d'alimentation électrique sur la phase d'injection ; et la valeur minimale de la tension efficace fournie par le réseau d'alimentation électrique sur chaque phase autre que la phase d'injection. Et, le second seuil est défini en considérant que les valeurs des tensions efficaces fournies par le réseau d'alimentation électrique sur lesdites phases sont identiques et en considérant : la valeur maximale de la capacité d'impédance entre la phase d'injection et le point de connexion au neutre; et la valeur minimale de la capacité d'impédance entre chaque phase autre que la phase d'injection et le point de connexion au neutre.

Selon un mode de réalisation particulier, le troisième seuil est défini en considérant : la valeur minimale de la capacité d'impédance entre la phase d'injection et le point de connexion au neutre ; la valeur maximale de la capacité de l'impédance entre chaque phase autre que la phase d'injection et le point de connexion au neutre; et la valeur minimale de la tension efficace fournie par le réseau d'alimentation électrique sur chaque phase. Et, le quatrième seuil est défini en considérant : la valeur maximale de la capacité d'impédance entre la phase d'injection et le point de connexion au neutre; la valeur minimale de la capacité d'impédance entre chaque phase autre que la phase d'injection et le point de connexion au neutre; et la valeur maximale de la tension efficace fournie par le réseau d'alimentation électrique sur chaque phase.

Selon un mode de réalisation particulier, l'indice R est calculé de la manière suivante :

$$R = \left(\sum_{n=2}^{N} V_n\right) / ((N - 1).V_1)$$

où N représente la quantité de phases auxquelles est connecté le compteur électrique polyphasé et *n* est un index strictement positif sur les phases, la phase d'index n = 1 étant la phase d'injection.

L'invention concerne également un procédé de gestion de détection d'absence de connexion d'un compteur électrique polyphasé à un neutre d'un réseau d'alimentation électrique alimentant une installation électrique pour laquelle le compteur électrique polyphasé doit effectuer des opérations de comptage d'énergie consommée. Ledit procédé de gestion est tel que le compteur électrique polyphasé met en oeuvre le procédé de détection d'absence de connexion du compteur électrique polyphasé au neutre du réseau d'alimentation électrique, tel que mentionné précédemment, dans l'un quelconque de ses modes de réalisation. Ledit procédé de gestion est en outre tel que le compteur électrique polyphasé applique des paramètres de calibration des opérations de comptage différents en fonction de la détection ou non d'absence de connexion du compteur électrique polyphasé au neutre du réseau d'alimentation électrique. Ainsi, une bonne précision de comptage est maintenue.

Selon un mode de réalisation particulier, le compteur électrique polyphasé applique un premier jeu de paramètres de calibration des opérations de comptage lorsque le compteur électrique polyphasé a détecté être correctement connecté au neutre du réseau d'alimentation électrique, et le compteur électrique polyphasé applique un second jeu de paramètres de calibration des opérations de comptage lorsque le compteur électrique polyphasé a détecté une absence de connexion d'un compteur électrique polyphasé au neutre du réseau d'alimentation électrique, lesdits premier et second jeux de paramètres étant prédéfinis.

Selon un mode de réalisation particulier, pour détecter une connexion correcte du compteur électrique polyphasé au neutre, le compteur électrique polyphasé effectue les étapes suivantes : comparer l'indice R avec des cinquième et sixième seuils, le cinquième seuil étant défini en appliquant une marge audit premier seuil de sorte que le cinquième seuil est strictement inférieur audit premier seuil, le sixième seuil étant défini en appliquant une marge audit second seuil de sorte que le sixième seuil est strictement supérieur audit second seuil ; comparer la valeur de tension efficace mesurée sur chaque phase autre que la phase d'injection avec des septième et huitième seuils, le septième seuil étant défini en appliquant une marge audit troisième seuil de sorte que le septième seuil est strictement inférieur audit troisième seuil, le huitième seuil étant défini en appliquant une marge audit quatrième seuil de sorte que le huitième seuil est strictement supérieur audit quatrième seuil; détecter que le compteur électrique est correctement connecté au neutre lorsque l'une au moins des conditions suivantes est remplie : l'indice R est strictement inférieur au cinquième seuil ou strictement supérieur au sixième seuil; et la valeur de tension efficace mesurée sur au moins une des phases auxquelles est connecté le compteur électrique polyphasé autre que la phase d'injection est strictement inférieure au septième seuil ou strictement supérieure au huitième seuil.

L'invention concerne également un compteur électrique polyphasé adapté pour détecter une absence de connexion du compteur électrique polyphasé à un neutre d'un réseau d'alimentation électrique, le compteur électrique polyphasé étant destiné à être connecté à une pluralité de phases du réseau d'alimentation électrique, le compteur électrique polyphasé étant adapté pour injecter dans le réseau d'alimentation électrique des signaux par courants porteurs en ligne via une phase d'injection parmi ladite pluralité, une impédance de capacité prédéfinie existant entre chaque phase et le neutre. Le compteur électrique polyphasé comporte : des moyens pour obtenir des mesures de tension efficace entre chaque phase et un point de connexion destiné à connecter le compteur électrique polyphasé au neutre ; des moyens pour calculer un indice R représentatif d'un rapport entre la tension efficace mesurée pour la phase d'injection et une somme des tensions efficaces mesurées pour les autres phases de ladite pluralité; des moyens pour comparer l'indice R avec des premier et second seuils, le premier seuil étant défini sur la base de la valeur minimale théorique de l'indice R et le second seuil étant défini sur la base de la valeur maximale théorique de l'indice R, au vu de tolérances de précision desdites capacités d'impédance et de tolérances de précision de tensions efficaces fournies par le réseau d'alimentation électrique via lesdites phases, lorsque le compteur électrique polyphasé n'est pas connecté au neutre ; des moyens pour comparer la valeur de tension efficace mesurée sur chaque phase autre que la phase d'injection avec des troisième et quatrième seuils, le troisième seuil étant défini sur la base de la valeur minimale théorique de tension efficace et le quatrième seuil étant défini sur la base de la valeur maximale théorique de tension efficace, au vu desdites tolérances de précision, lorsque le compteur électrique polyphasé n'est pas connecté au neutre; et des moyens pour détecter que le compteur électrique n'est pas connecté au neutre lorsque les conditions suivantes sont remplies : l'indice R est supérieur ou égal au premier seuil et est inférieur ou égal au second seuil ; et la valeur de tension efficace mesurée sur chaque phase à laquelle est connecté le compteur électrique polyphasé autre que la phase d'injection est supérieure ou égale au troisième seuil et est inférieure ou égale au quatrième seuil.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1A illustre schématiquement un système électrique dans lequel l'invention peut être mise en oeuvre;
- la Fig. 1B représente un schéma de principe de connexion à un réseau d'alimentation électrique triphasé;
- la Fig. 2 illustre schématiquement un exemple d'architecture matérielle partielle d'un compteur électrique au sein du système électrique;
- la Fig. 3 illustre schématiquement un premier algorithme de gestion de détection d'absence de connexion à un fil de neutre d'un réseau d'alimentation électrique polyphasé; et
- la Fig. 4 illustre schématiquement un second algorithme de gestion de détection d'absence de connexion au fil de neutre du réseau d'alimentation électrique polyphasé.

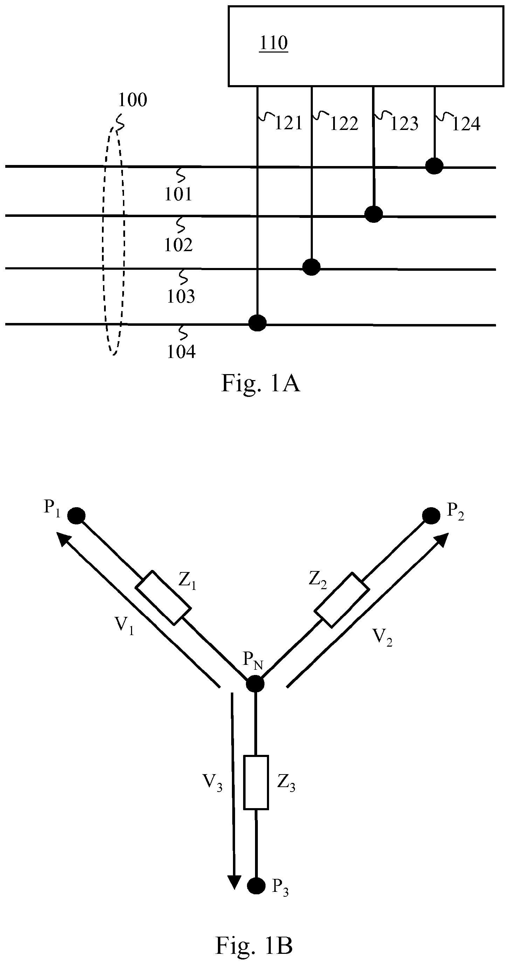

La Fig. 1A illustre schématiquement un système électrique dans lequel l'invention peut être mise en oeuvre.

Le système électrique de la Fig. 1A comporte un réseau d'alimentation électrique 100 constitué d'une pluralité de fils, un fil étant dédié au neutre et au moins deux fils étant dédiés à au moins deux phases respectives. Dans l'exemple de réalisation représenté par la Fig. 1A, le réseau d'alimentation électrique 100 est un système triphasé, et est donc constitué de quatre fils : un fil de neutre 104, un fil de première phase 101, un fil de seconde phase 102 et un fil de troisième phase 103. Le système électrique de la Fig. 1A peut toutefois reposer sur un réseau d'alimentation électrique polyphasé avec un nombre différent de fils de phase.

Le système électrique de la Fig. 1A comporte en outre un compteur électrique polyphasé 110, c'est-à-dire un dispositif servant à effectuer des opérations de comptage de quantité d'énergie électrique consommée par une installation électrique que le compteur électrique polyphasé 110 est en charge de superviser. Le compteur électrique polyphasé 110 est connecté à une pluralité de fils de phase du réseau d'alimentation électrique 100, ainsi qu'au fil de neutre 104. Dans l'exemple de réalisation représenté par la Fig. 1A, le compteur électrique polyphasé 110 est destiné à être connecté aux quatre fils 101, 102, 103 et 104 du réseau d'alimentation électrique 100 par des points de connexion respectifs 124, 123, 122 et 121. Le compteur électrique polyphasé 110 peut être destiné à être connecté à une quantité moindre de fils de phase que la quantité de fils de phase disponibles dans le réseau d'alimentation électrique 100.

Dans le cadre de la présente invention, le compteur électrique polyphasé 110 est adapté pour communiquer avec un concentrateur de données DC dans un cadre de gestion avancée de comptage AMM. Les communications entre le compteur électrique polyphasé 110 et le concentrateur de données DC sont mises en oeuvre par courants porteurs en ligne PLT. Ces communications par courants porteurs en ligne PLT permettent notamment au compteur électrique polyphasé 110 de fournir, au concentrateur de données DC des informations de comptage de quantité d'énergie électrique consommée par l'installation électrique que le compteur électrique polyphasé 110 est en charge de superviser. Les signaux par courants porteurs en ligne PLT sont injectés par le compteur électrique polyphasé 110 via une des phases auxquelles est connecté le compteur électrique polyphasé 110, les autres n'étant pas utilisées par le compteur électrique polyphasé 110 pour communiquer dans le cadre de gestion avancée de comptage AMM. Cette injection de signaux par courants porteurs en ligne PLT entraîne un déséquilibre entre les phases auxquelles est connecté le compteur électrique polyphasé 110, lorsque le compteur électrique polyphasé 110 n'est pas connecté au neutre du réseau d'alimentation électrique.

Afin de permettre d'effectuer des opérations de comptage précises, le compteur électrique polyphasé 110 est adapté pour appliquer des paramètres de calibration. En effet, les tolérances de précision applicables aux caractéristiques de divers composants du compteur électrique polyphasé 110 par rapport aux spécifications du compteur électrique polyphasé 110 peuvent engendrer des imprécisions de comptage. Ces paramètres de calibration sont typiquement déterminés par test de calibration en usine, en injectant dans le compteur électrique polyphasé 110 un signal de puissance connue, en activant ensuite des opérations de comptage et en déterminant les paramètres de calibration de manière à assurer que les opérations de comptage mènent à un comptage d'énergie consommée correspondant à la puissance injectée. Les paramètres de calibration sont donc des facteurs de correction du résultat des opérations de comptage effectuées par le compteur électrique polyphasé 110. On peut noter que le terme « ajustement » est aussi utilisé pour faire référence à la calibration des compteurs électriques.

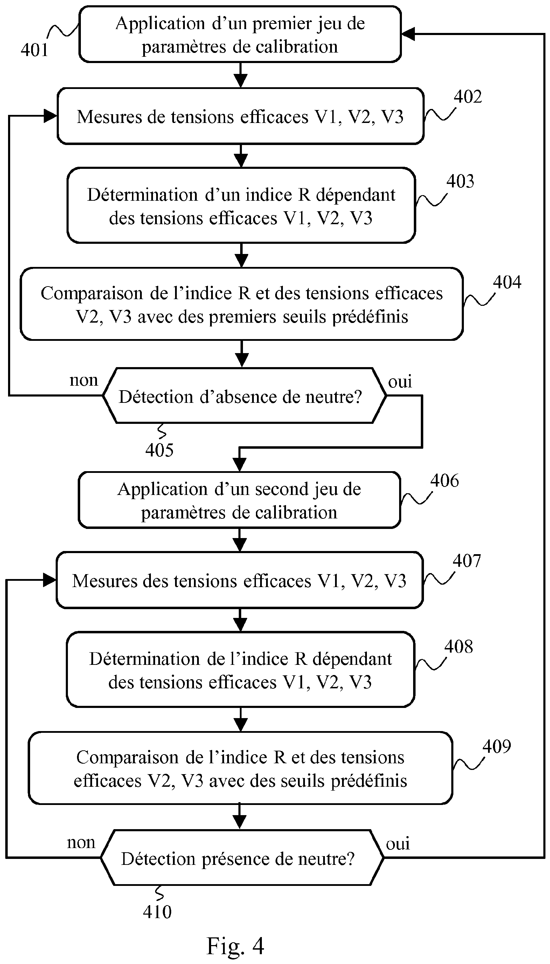

Dans un mode de réalisation particulier, tel que détaillé par la suite en relation avec la Fig. 4, le compteur électrique polyphasé 110 est adapté pour sélectionner un jeu de paramètres de calibration, en fonction du fait que le compteur électrique polyphasé 110 a détecté ou non une absence de connexion au fil de neutre 104. Dans ce cas, le compteur électrique polyphasé 110 a subi un premier test de calibration en usine dans un premier mode où le compteur électrique polyphasé 110 est correctement connecté au fil de neutre et a subi un second test de calibration en usine dans un second mode où le compteur électrique polyphasé 110 n'est pas connecté au fil de neutre. Ces premier et second tests de calibration donnent respectivement des premier et second jeux de paramètres de calibration, parmi lesquels le compteur électrique polyphasé 110 est amené à choisir en fonction du fait que le compteur électrique polyphasé 110 a détecté ou non une absence de connexion au fil de neutre 104.

La Fig. 1B représente un schéma de principe de couplage du compteur électrique 110 à un réseau d'alimentation électrique triphasé, tel que le réseau d'alimentation électrique 100. Dans le cadre de la Fig. 1B, le compteur électrique 110 est triphasé. $P_1$ représente le potentiel vu par le compteur électrique polyphasé 110 pour une première phase du réseau d'alimentation électrique triphasé, via laquelle les signaux par courants porteurs en ligne PLT sont injectés. $P_2$ représente le potentiel vu par le compteur électrique polyphasé 110 pour une seconde phase du réseau d'alimentation électrique triphasé. $P_3$ représente le potentiel vu par le compteur électrique polyphasé 110 pour une troisième phase du réseau d'alimentation électrique triphasé. $P_N$ représente le potentiel vu par le compteur électrique polyphasé 110 pour le neutre. Considérons donc par la suite que le potentiel $P_1$ est obtenu au point de connexion 124, que le potentiel $P_2$ est obtenu au point de connexion 123, que le potentiel $P_3$ est obtenu au point de connexion 122 et que le potentiel $P_N$ est obtenu au point de connexion 121.

La Fig. 1B représente donc un schéma de principe de couplage en étoile, aussi appelé couplage Wye (pour la lettre « Y » en anglais), dans lequel le couplage vu du compteur électrique 110 entre la phase associée au potentiel $P_1$ et le neutre représenté par $P_N$ est représenté par une impédance $Z_1$ de capacité $C_1$, le couplage vu du compteur électrique 110 entre la phase associée au potentiel $P_2$ et le neutre représenté par $P_N$ est représenté par une impédance $Z_2$ de capacité $C_2$, et le couplage vu du compteur électrique 110 entre la phase associée au potentiel $P_3$ et le neutre représenté par $P_N$ est représenté par une impédance $Z_3$ de capacité $C_3$. Par exemple, les valeurs nominales respectives des capacités $C_1$, $C_2$ et $C_3$ peuvent être spécifiées de la manière suivante: $C_1 = 570$ nF, $C_2 = 100$ nF et $C_3 = 100$ nF. Etant donné qu'une mise en pratique ne peut pas être parfaitement conforme à une valeur théorique souhaitée, une certaine tolérance de précision $\delta C$, e.g. ± 20%, doit être prise en compte. Cette tolérance correspond en général à des exigences de performances et/ou de conception et peut prendre différentes valeurs selon les cas.

Lorsque le compteur électrique 110 est correctement connecté au fil de neutre 104, les potentiels $P_1$, $P_2$ et $P_3$ peuvent être exprimés de la façon suivante :

$$P_1 = U_1 . \sqrt{2} . e^{jwt}$$

$$P_2 = U_2 . \sqrt{2} . e^{j(wt - 2\pi/3)}$$

$$P_3 = U_3 . \sqrt{2} . e^{j(wt + 2\pi/3)}$$

où $j$ représente l'unité imaginaire, où t représente le temps, où $U_1$, $U_2$ et $U_3$ représentent respectivement les tensions efficaces des signaux alternatifs fournis via les première, seconde et troisième phases du réseau d'alimentation électrique 100, et où w est la pulsation du signal alternatif fourni via les première, seconde et troisième phases du réseau d'alimentation électrique 100. Par exemple, les valeurs nominales des tensions efficaces $U_1$, $U_2$ et $U_3$ peuvent être spécifiées à 230 V chacune. Etant donné qu'une mise en pratique ne peut pas être parfaitement conforme à une valeur théorique souhaitée, une certaine tolérance de précision $\delta U$, e.g. ± 10%, doit être prise en compte. Cette tolérance correspond en général à des exigences de qualité de fourniture d'électricité et peut prendre différentes valeurs selon les cas.

Lorsque le compteur électrique 110 n'est pas connecté au fil de neutre 104, la tension efficace $V_1$ vue par le compteur électrique 110 entre le potentiel $P_1$ et le potentiel $P_N$, la tension efficace $V_2$ vue par le compteur électrique 110 entre le potentiel $P_2$ et le potentiel $P_N$ et la tension efficace $V_3$ vue par le compteur électrique 110 entre le potentiel $P_3$ et le potentiel $P_N$ peuvent alors être exprimées de la manière suivante :

$$V_1 = U_1 . \sqrt{(1 - x)^2 + y^2}$$

$$V_2 = U_1 . \sqrt{\left(-\frac{U_2}{2.U_1} - x\right)^2 + \left(-\frac{\sqrt{3}.U_2}{2.U_1} - y\right)^2}$$

$$V_3 = U_1 . \sqrt{\left(-\frac{U_3}{2.U_1} - x\right)^2 + \left(-\frac{\sqrt{3}.U_3}{2.U_1} - y\right)^2}$$

avec

$$x = \left(C_1 - \frac{U_2.C_2 + U_3.C_3}{2.U_1}\right) / (C_1 + C_2 + C_3)$$

$$y = \frac{\sqrt{3}}{2} . \left(\frac{U_3.C_3 - U_2.C_2}{U_1.(C_1 + C_2 + C_3)}\right)$$

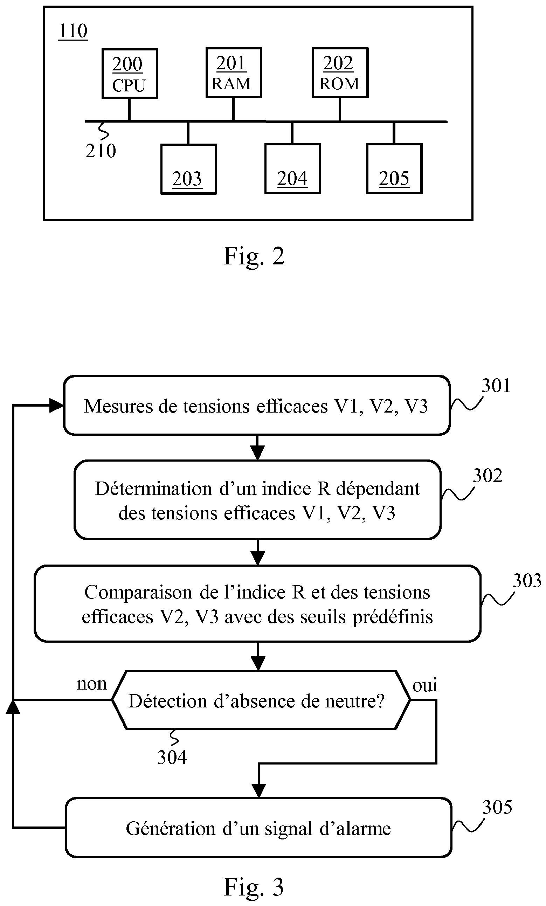

A partir des formules ci-dessus, il est donc possible de déterminer quelle est la plage de valeurs que peuvent prendre les tensions efficaces $V_2$ et $V_3$ en fonction des tolérances de précision applicables aux capacités $C_1$, $C_2$ et $C_3$ et des tolérances de précision applicables aux tensions efficaces $U_1$, $U_2$ et $U_3$. Il en va de même vis-à-vis d'un indice qui serait représentatif d'un rapport entre une somme des tensions efficaces mesurées sur les phases autres que celle sur laquelle les signaux par courants porteurs en ligne PLT sont injectés et la tension efficace mesurée sur la phase sur laquelle les signaux par courants porteurs en ligne PLT sont injectés. La mise en oeuvre d'un tel indice est détaillée par la suite en relation avec les Figs. 3 et 4.

Pour des réseaux d'alimentation électrique autres que des réseaux d'alimentation triphasés (comme par exemple les réseaux biphasés utilisés aux Etats-Unis et ceux utilisés au Japon), l'homme du métier est alors capable de dériver des formules ci-dessus la plage de valeurs que peut prendre, pour une phase considérée à laquelle le compteur électrique polyphasé est connecté, la tension efficace entre le point de connexion à ladite phase et le point de connexion au neutre. Il en va de même pour l'indice susmentionné.

La Fig. 2 illustre schématiquement un exemple d'architecture du compteur électrique polyphasé 110. Le compteur électrique polyphasé 110 comporte alors, reliés par un bus de communication 210 : un processeur ou CPU (« Central Processing Unit » en anglais) 200 ; une mémoire vive RAM (« Random Access Memory » en anglais) 201 ; une mémoire morte ROM (« Read Only Memory » en anglais) 202 ; une unité de stockage ou un lecteur de support de stockage, tel qu'un lecteur de cartes SD (« Secure Digital » en anglais) 203 ; une interface homme-machine 204 permettant au compteur électrique polyphasé 110 d'interagir avec un utilisateur pour fournir des indications de comptage d'énergie consommée par l'installation électrique supervisée par ledit compteur électrique polyphasé 110 ; et une interface 205 de communication par courants porteurs en ligne PLT, permettant au compteur électrique 110 de fournir, à un concentrateur de données DC dans un cadre de gestion avancée de comptage AMM, des indications de comptage d'énergie consommée par l'installation électrique supervisée par compteur électrique 110.

Le processeur 200 est capable d'exécuter des instructions chargées dans la RAM 201 à partir de la ROM 202, d'une mémoire externe (non représentée), d'un support de stockage, tel qu'une carte SD, ou d'un réseau de communication. Lorsque le compteur électrique polyphasé 110 est mis sous tension, le processeur 200 est capable de lire de la RAM 201 des instructions et de les exécuter. Ces instructions forment un programme d'ordinateur causant la mise en oeuvre, par le processeur 200, de tout ou partie des algorithmes décrits ci-après.

Tout ou partie des algorithmes décrits ci-après peut être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant dédié, tel qu'un FPGA (« Field-Programmable Gate Array » en anglais) ou un ASIC (« Application-Specific Integrated Circuit » en anglais).

La Fig. 3 illustre schématiquement un premier algorithme de gestion de détection d'absence de connexion à un fil de neutre d'un réseau d'alimentation électrique polyphasé. Le premier algorithme de gestion représenté à la Fig. 3 est mis en oeuvre par un compteur électrique polyphasé. Considérons par la suite que l'algorithme de la Fig. 3 est mis en oeuvre par le compteur électrique polyphasé 110.

Dans le cadre du premier algorithme de gestion représenté à la Fig. 3, une alarme est déclenchée en cas de détection d'absence de connexion au fil de neutre du réseau d'alimentation électrique polyphasé. L'algorithme de la Fig. 3 définit donc un premier cadre de mise en oeuvre d'un procédé de détection d'absence de connexion au fil de neutre du réseau d'alimentation électrique polyphasé.

Dans une étape 301, le compteur électrique polyphasé 110 effectue une mesure des tensions efficaces entre le point de connexion de chacune des phases auxquelles le compteur électrique polyphasé 110 est connecté et le point de connexion du compteur électrique polyphasé 110 auquel le fil de neutre est supposé être connecté. Dans le cadre du réseau d'alimentation électrique triphasé 100, tel que schématiquement représenté à la Fig. 1B, le compteur électrique polyphasé 110 effectue une mesure de la tension efficace $V_1$ entre le point de connexion 121 et le point de connexion 124, une mesure de la tension efficace $V_2$ entre le point de connexion 121 et le point de connexion 123 et une mesure de la tension efficace $V_3$ entre le point de connexion 121 et le point de connexion 122.

Dans une étape 302 suivante, le compteur électrique polyphasé 110 détermine un indice R représentatif d'un rapport entre une somme des tensions efficaces $V_n$ $V_n$ (lorsque $n > 1$) mesurées sur les phases «n» autres que celle sur laquelle les signaux par courants porteurs en ligne PLT sont injectés et la tension efficace $V_1$ (*i.e.* lorsque $n = 1$) mesurée sur la phase sur laquelle les signaux par courants porteurs en ligne PLT sont injectés. Par exemple, l'indice R est défini de la manière suivante :

$$R = \left(\sum_{n=2}^{N} V_n\right) / ((N-1).V_1)$$

où « $N$ » représente la quantité de phases auxquelles est connecté le compteur électrique polyphasé 110 *et «n»* est un index sur ces phases ($n \geq 1$), la phase d'index $n = 1$ étant celle sur laquelle les signaux par courants porteurs en ligne PLT sont injectés.

Ainsi, dans le cas du réseau d'alimentation électrique triphasé 100, l'indice R peut être exprimé de la manière suivante :

$$R = \frac{V_2 + V_3}{2.V_1}$$

On peut remarquer qu'avec cette définition, l'indice R tend vers la valeur « 1 » lorsque le système électrique est substantiellement équilibré. L'indice R est préférentiellement calculé par intégration sur une période prédéfinie, par exemple de durée égale à 30 s.

Dans une étape 303 suivante, le compteur électrique polyphasé 110 compare l'indice R calculé avec un premier seuil prédéfini Th_R_low et un second seuil prédéfini Th_R_high.

Le premier seuil Th_R_low est défini d'après les tolérances de précision respectivement applicables, selon les spécifications du compteur électrique polyphasé 110, aux valeurs des capacités des impédances du réseau d'alimentation électrique entre le point de connexion de chaque phase et le point de connexion au neutre (*i. e.* les capacités $C_1$, $C_2$ et $C_3$ dans le cadre du schéma de principe de la Fig. 1B), ainsi qu'aux valeurs de tension efficace fournies par le réseau d'alimentation électrique au compteur électrique polyphasé 110 (*i. e.* les valeurs efficaces $U_1$, $U_2$ et $U_3$ dans le cadre du schéma de principe de la Fig. 1B). Le second seuil Th_R_high est défini d'après les tolérances de précision respectivement applicables, selon les spécifications du compteur électrique polyphasé 110, aux valeurs des capacités des impédances du réseau d'alimentation électrique entre le point de connexion de chaque phase et le point de connexion au neutre (*i.e.* les capacités $C_1$, $C_2$ et $C_3$ dans le cadre du schéma de principe de la Fig. 1B). En d'autres termes, le premier seuil Th_R_low est défini sur la base de la valeur minimale théorique de l'indice R et le second seuil Th_R_high est défini sur la base de la valeur maximale théorique de l'indice R, au vu des tolérances de précision $\delta C$ desdites capacités d'impédance et de tolérances de précision $\delta U$ des tensions efficaces fournies par le réseau d'alimentation électrique via les phases, lorsque le compteur électrique polyphasé 110 n'est pas connecté au neutre.

Plus précisément, le premier seuil Th_R_low est défini en considérant :

- la valeur minimale de la capacité de l'impédance entre le point de connexion de la phase sur laquelle sont injectés les signaux par courants porteurs en ligne PLT et le point de connexion au neutre;
- la valeur maximale de la capacité de l'impédance entre le point de connexion de chaque autre phase sur laquelle est connecté le compteur électrique polyphasé 110 et le point de connexion au neutre;
- la valeur maximale de la tension efficace fournie par le réseau d'alimentation électrique sur la phase sur laquelle sont injectés les signaux par courants porteurs en ligne PLT; et
- la valeur minimale de la tension efficace fournie par le réseau d'alimentation électrique sur chaque autre phase sur laquelle est connecté le compteur électrique polyphasé 110.

De plus, le second seuil Th_R_high est défini en considérant:

- la valeur maximale de la capacité de l'impédance entre le point de connexion de la phase sur laquelle sont injectés les signaux par courants porteurs en ligne PLT et le point de connexion au neutre;
- la valeur minimale de la capacité de l'impédance entre le point de connexion de chaque autre phase sur laquelle est connecté le compteur électrique polyphasé 110 et le point de connexion au neutre;

et en considérant que les valeurs des tensions efficaces $U_1$, $U_2$ et $U_3$ fournies par le réseau d'alimentation électrique sur lesdites phases sont identiques.

En considérant les valeurs de capacité $C_1$, $C_2$ et $C_3$ déjà utilisées en exemple (*i.e.* 570 nF, 100 nF, 100 nF respectivement, avec une tolérance de précision égale à $\pm$ 20 %) et les valeurs de tension efficace $U_1$, $U_2$ et $U_3$ déjà utilisées en exemple (*i.e.* 230 V chacune, avec une tolérance de précision égale à $\pm$ 10 %), le premier seuil Th_R_low prend la valeur « 2,4 » et le second seuil Th_R_high prend la valeur « 5,25 ». Dans cet exemple illustratif, la valeur du premier seuil Th_R_low a été fixée en considérant que :

- la valeur de la capacité $C_1$ est égale à la valeur minimale autorisée au vu de la tolérance de précision applicable, soit $C_1$ = 456 nF ;
- la valeur de la capacité $C_2$ est égale à la valeur maximale autorisée au vu de la tolérance de précision applicable, soit $C_2$ = 120 nF ;
- la valeur de la capacité $C_3$ est égale à la valeur maximale autorisée au vu de la tolérance de précision applicable, soit $C_3$ = 120 nF ;
- la valeur de la tension efficace $U_1$ est égale à la valeur maximale autorisée au vu de la tolérance de précision applicable, soit $U_1$ = 253 V ;
- la valeur de la tension efficace $U_2$ est égale à la valeur minimale autorisée au vu de la tolérance de précision applicable, soit $U_2$ = 207 V ; et
- la valeur de la tension efficace $U_3$ est égale à la valeur minimale autorisée au vu de la tolérance de précision applicable, soit $U_3$ = 207 V.

De plus, dans cet exemple illustratif, la valeur du second seuil Th_R_high a été fixée en considérant que :

- les valeurs des tensions efficaces $U_1$, $U_2$ et $U_3$ fournies par le réseau d'alimentation électrique sur les phases sont identiques, quelles que soient ces valeurs;
- la valeur de la capacité $C_1$ est égale à la valeur maximale autorisée au vu de la tolérance de précision applicable, soit $C_1$ = 684 nF ;
- la valeur de la capacité $C_2$ est égale à la valeur minimale autorisée au vu de la tolérance de précision applicable, soit $C_2$ = 80 nF ; et
- la valeur de la capacité $C_3$ est égale à la valeur minimale autorisée au vu de la tolérance de précision applicable, soit $C_3$ = 80 nF.

Certaines marges $\varepsilon_{Rl}$ et $\varepsilon_{Rh}$ peuvent être respectivement appliquées dans la définition des premier Th_R_low et second Th_R_high seuils, pour compenser des incertitudes de mesures. Par exemple, en repartant des valeurs obtenues ci-dessus, le premier seuil Th_R_low peut être ajusté à la valeur « 2,25 » et le second seuil Th_R_high peut être ajusté à la valeur « 5,4 ».

En outre, dans l'étape 303, le compteur électrique polyphasé 110 compare la valeur des tensions efficaces $V_2$ et $V_3$ mesurées avec un troisième seuil prédéfini Th_V_low et un quatrième seuil prédéfini Th_V_high.

Les troisième Th_V_low et quatrième Th_V_high seuils sont définis d'après les tolérances de précision respectivement applicables, selon les spécifications du compteur électrique polyphasé 110, aux valeurs des capacités des impédances du réseau d'alimentation électrique entre le point de connexion de chaque phase et le point de connexion au neutre (*i. e.* les capacités $C_1$, $C_2$ et $C_3$ dans le cadre du schéma de principe de la Fig. 1B), ainsi qu'aux valeurs de tension efficace fournies par le réseau d'alimentation électrique au compteur électrique polyphasé 110 (*i.e.* les valeurs de tension efficace $U_1$, $U_2$ et $U_3$ dans le cadre du schéma de principe de la Fig. 1B). En d'autres termes, le troisième seuil Th_V_low est défini sur la base de la valeur minimale théorique de tension efficace et le quatrième seuil Th_V_high est défini sur la base de la valeur maximale théorique de tension efficace, au vu desdites tolérances de précision $\delta C$ et $\delta U$, lorsque le compteur électrique polyphasé n'est pas connecté au neutre.

Plus précisément, le troisième seuil Th_V_low est défini en considérant :

- la valeur minimale de la capacité de l'impédance entre le point de connexion de la phase sur laquelle sont injectés les signaux par courants porteurs en ligne PLT et le point de connexion au neutre ;
- la valeur maximale de la capacité de l'impédance entre le point de connexion de chaque autre phase sur laquelle est connecté le compteur électrique polyphasé 110 et le point de connexion au neutre ; et
- la valeur minimale de la tension efficace fournie par le réseau d'alimentation électrique sur chaque phase sur laquelle est connecté le compteur électrique polyphasé 110.

De plus, le quatrième seuil Th_V_high est défini en considérant :

- la valeur maximale de la capacité de l'impédance entre le point de connexion de la phase sur laquelle sont injectés les signaux par courants porteurs en ligne PLT et le point de connexion au neutre ;
- la valeur minimale de la capacité de l'impédance entre le point de connexion de chaque autre phase sur laquelle est connecté le compteur électrique polyphasé 110 et le point de connexion au neutre ; et
- la valeur maximale de la tension efficace fournie par le réseau d'alimentation électrique sur chaque phase sur laquelle est connecté le compteur électrique polyphasé 110.

En considérant les valeurs de capacité $C_1$, $C_2$ et $C_3$ déjà utilisées en exemple *(i.e.* 570 nF, 100 nF, 100 nF respectivement, avec une tolérance de précision égale à $\pm$ 20 %) et les valeurs de tension efficaces $U_1$, $U_2$ et $U_3$ déjà utilisées en exemple *(i.e.* 230 V chacune, avec une tolérance de précision égale à $\pm$ 10 %), le troisième seuil Th_V_low prend la valeur 271,1 V et le quatrième seuil Th_V_high prend la valeur 377,7 V. Dans cet exemple illustratif, la valeur du troisième seuil Th_V_low a été fixée en considérant que :

- la valeur de la capacité $C_1$ est égale à la valeur minimale autorisée au vu de la tolérance de précision applicable, soit $C_1$ = 456 nF ;
- la valeur de la capacité $C_2$ est égale à la valeur maximale autorisée au vu de la tolérance de précision applicable, soit $C_2$= 120 nF ;
- la valeur de la capacité $C_3$ est égale à la valeur maximale autorisée au vu de la tolérance de précision applicable, soit $C_3$ = 120 nF ;
- la valeur de la tension efficace $U_1$ est égale à la valeur minimale autorisée au vu de la tolérance de précision applicable, soit $U_1$ = 207 V ;
- la valeur de la tension efficace $U_2$ est égale à la valeur minimale autorisée au vu de la tolérance de précision applicable, soit $U_2$= 207 V ; et
- la valeur de la tension efficace $U_3$ est égale à la valeur minimale autorisée au vu de la tolérance de précision applicable, soit $U_3$ = 207 V.

De plus, dans cet exemple illustratif, la valeur du quatrième seuil Th_V_high a été fixée en considérant que :

- la valeur de la capacité $C_1$ est égale à la valeur maximale autorisée au vu de la tolérance de précision applicable, soit $C_1$ = 684 nF ;
- la valeur de la capacité $C_2$ est égale à la valeur minimale autorisée au vu de la tolérance de précision applicable, soit $C_2$= 80 nF ;
- la valeur de la capacité $C_3$ est égale à la valeur minimale autorisée au vu de la tolérance de précision applicable, soit $C_3$ = 80 nF ;
- la valeur de la tension efficace $U_1$ est égale à la valeur maximale autorisée au vu de la tolérance de précision applicable, soit $U_1$ = 253 V ;
- la valeur de la tension efficace $U_2$ est égale à la valeur maximale autorisée au vu de la tolérance de précision applicable, soit $U_2$ = 253 V ; et
- la valeur de la tension efficace $U_3$ est égale à la valeur maximale autorisée au vu de la tolérance de précision applicable, soit $U_3$ = 253 V.

Certaines marges $\varepsilon_{Vl}$ et $\varepsilon_{Vh}$ peuvent être respectivement appliquées dans la définition des troisième Th_V_low et quatrième Th_V_high seuils, pour compenser des incertitudes de mesures. Par exemple, en repartant des valeurs obtenues ci-dessus, le troisième seuil Th_V_low peut être ajusté à la valeur 265 V et le quatrième seuil Th_V_high peut être ajusté à la valeur 383 V.

Dans une étape 304 suivante, le compteur électrique polyphasé 110 considère qu'il y a absence de connexion au fil de neutre 104, lorsque les comparaisons effectuées à l'étape 303 montrent que le système d'équations suivant est respecté :

$$\begin{cases} \text{Th\_R\_low} \leq R \leq \text{Th\_R\_high} \\ \text{Th\_V\_low} \leq V_2 \leq \text{Th\_V\_high} \\ \text{Th\_V\_low} \leq V_3 \leq \text{Th\_V\_high} \end{cases}$$

Dans le cas où le compteur électrique polyphasé 110 considère qu'il y a absence de connexion au fil de neutre 104, une étape 305 est effectuée ; sinon, l'étape 301 est réitérée.

Dans l'étape 305, le compteur électrique polyphasé 110 génère un signal d'alarme indiquant que le compteur électrique polyphasé 110 n'est pas connecté au fil de neutre 104. Un tel signal d'alarme peut être un signal sonore, déclenché par le compteur électrique polyphasé 110 grâce à un haut-parleur intégré ou connecté au compteur électrique polyphasé 110. Un tel signal d'alarme peut aussi être un signal lumineux ou visuel, déclenché par le compteur électrique polyphasé 110 grâce à un voyant ou un écran intégré ou connecté au compteur électrique polyphasé 110. Un tel signal d'alarme peut aussi être un message, sous la forme de signaux par courants porteurs en ligne PLT, transmis par le compteur électrique polyphasé 110 à un concentrateur de données DC.

Il est considéré dans le cadre de l'algorithme de la Fig. 3 qu'un tel signal d'alarme est généré tant que le compteur électrique polyphasé 110 considère qu'il y a absence de connexion au fil de neutre 104. Il est cependant possible de générer un tel signal d'alarme uniquement si le compteur électrique polyphasé 110 considère qu'il y a absence de connexion au fil de neutre 104 pendant au moins une période de temps prédéfinie. Il est aussi possible de générer un tel signal d'alarme avec une périodicité prédéfinie, tant que le compteur électrique polyphasé 110 considère qu'il y a absence de connexion au fil de neutre 104.

Il est aussi possible de mettre en place un mécanisme d'hystérésis pour éviter des instabilités dans la génération de tels signaux d'alarme. Un tel mécanisme d'hystérésis est détaillé ci-après en relation avec la Fig. 4.

Il est aussi possible, en remplacement ou en complément des signaux d'alarme susmentionnés, d'appliquer des paramètres de calibration des opérations de comptage différents, en fonction du fait que le compteur électrique polyphasé 110 considère ou non qu'il y a absence de connexion au fil de neutre 104. Cet aspect est aussi détaillé ci-après en relation avec la Fig. 4.

La Fig. 4 illustre schématiquement un second algorithme de gestion de détection d'absence de connexion à un fil de neutre d'un réseau d'alimentation électrique polyphasé. Le second algorithme de gestion représenté à la Fig. 4 est mis en oeuvre par un compteur électrique polyphasé. Considérons par la suite que l'algorithme de la Fig. 4 est mis en oeuvre par le compteur électrique polyphasé 110.

Dans le cadre du second algorithme de gestion représenté à la Fig. 4, une modification de paramètres de calibration des opérations de comptage est déclenchée en cas de détection d'absence de connexion au fil de neutre du réseau d'alimentation électrique polyphasé. L'algorithme de la Fig. 4 définit donc un second cadre de mise en oeuvre du procédé de détection d'absence de connexion au fil de neutre du réseau d'alimentation électrique polyphasé.

Dans une étape 401, le compteur électrique polyphasé 110 applique un premier jeu de paramètres de calibration des opérations de comptage, qui est adapté au comptage d'énergie électrique consommée par l'installation électrique supervisée par le compteur électrique polyphasé 110 lorsque ledit compteur électrique polyphasé 110 est correctement connecté au fil de neutre 104 du réseau d'alimentation électrique 100.

Dans une étape 402 suivante, le compteur électrique polyphasé 110 effectue une mesure des tensions efficaces entre le point de connexion de chacune des phases auxquelles le compteur électrique polyphasé 110 est connecté et le point de connexion du compteur électrique polyphasé 110 auquel le fil de neutre est supposé être connecté. Dans le cadre du réseau d'alimentation électrique triphasé 100, tel que schématiquement représenté à la Fig. 1B, le compteur électrique polyphasé 110 effectue une mesure de la tension efficace $V_1$ entre le point de connexion 121 et le point de connexion 124, une mesure de la tension efficace $V_2$ entre le point de connexion 121 et le point de connexion 123 et une mesure de la tension efficace $V_3$ entre le point de connexion 121 et le point de connexion 122.

Dans une étape 403 suivante, le compteur électrique polyphasé 110 détermine l'indice R, tel que précédemment défini en relation avec la Fig. 3.

Dans une étape 404 suivante, le compteur électrique polyphasé 110 compare l'indice R calculé (à l'étape 403) avec le premier seuil Th_R_low et le second seuil Th R high, tels que précédemment définis en relation avec la Fig. 3. Comme précédemment, en considérant les valeurs de capacité $C_1$, $C_2$ et $C_3$ déjà mentionnées (*i.e.* 570 nF, 100 nF, 100 nF respectivement, avec une tolérance de précision égale à $\pm 20$ %) et les valeurs de tension efficace $U_1$, $U_2$ et $U_3$ déjà mentionnées *(i.e.* 230 V chacune, avec une tolérance de précision égale à $\pm$ 10 %), le premier seuil Th_R_low prend la valeur « 2,4 » et le second seuil Th_R_high prend la valeur « 5,25 ». Les marges $\varepsilon_{Rl}$ et $\varepsilon_{Rh}$ peuvent être respectivement appliquées dans la définition des premiers Th_R_low et second Th_R_high seuils, pour compenser des incertitudes de mesures.

En outre, dans l'étape 404, le compteur électrique polyphasé 110 compare la valeur des tensions efficaces $V_2$ et $V_3$ mesurées (à l'étape 402) avec le troisième seuil Th_V_low et le quatrième seuil Th_V_high. Comme précédemment, en considérant les valeurs de capacité $C_1$, $C_2$ et $C_3$ déjà mentionnées *(i.e.* 570 nF, 100 nF, 100 nF respectivement, avec une tolérance de précision égale à ± 20 %) et les valeurs de tension efficace $U_1$, $U_2$ et $U_3$ déjà mentionnées *(i.e.* 230 V chacune, avec une tolérance de précision égale à ± 10 %), le troisième seuil Th_V_low prend la valeur 271,1 V et le quatrième seuil Th_V_high prend la valeur 377,7 V. Les marges $\varepsilon_{Vl}$ et $\varepsilon_{Vh}$ peuvent être respectivement appliquées dans la définition des troisième Th_V_low et quatrième Th_V_high seuils, pour compenser des incertitudes de mesures.

Dans une étape 405 suivante, le compteur électrique polyphasé 110 considère qu'il y a absence de connexion au fil de neutre 104, lorsque les comparaisons effectuées à l'étape 404 montrent que le système d'équations suivant (identique à celui présenté en relation avec la Fig. 3) est respecté :

$$\begin{cases} \text{Th\_R\_low} \leq R \leq \text{Th\_R\_high} \\ \text{Th\_V\_low} \leq V_2 \leq \text{Th\_V\_high} \\ \text{Th\_V\_low} \leq V_3 \leq \text{Th\_V\_high} \end{cases}$$

Dans le cas où le compteur électrique polyphasé 110 considère qu'il y a absence de connexion au fil de neutre 104, une étape 406 est effectuée ; sinon, l'étape 402 est réitérée.

Dans l'étape 406, le compteur électrique polyphasé 110 applique un second jeu de paramètres de calibration des opérations de comptage, qui est adapté au comptage d'énergie électrique consommée par l'installation électrique supervisée par le compteur électrique polyphasé 110 lorsque ledit compteur électrique polyphasé 110 n'est pas correctement connecté au fil de neutre 104 du réseau d'alimentation électrique 100.

Dans une étape 407 suivante, le compteur électrique polyphasé 110 effectue une mesure des tensions efficaces entre le point de connexion de chacune des phases auxquelles le compteur électrique polyphasé 110 est connecté et le point de connexion du compteur électrique polyphasé 110 auquel le fil de neutre est supposé être connecté. Dans le cadre du réseau d'alimentation électrique triphasé 100, tel que schématiquement représenté à la Fig. 1B, le compteur électrique polyphasé 110 effectue une mesure de la tension efficace $V_1$ entre le point de connexion 121 et le point de connexion 124, une mesure de la tension efficace $V_2$ entre le point de connexion 121 et le point de connexion 123 et une mesure de la tension efficace $V_3$ entre le point de connexion 121 et le point de connexion 122. En d'autres termes, le compteur électrique polyphasé 110 effectue les mêmes mesures qu'à l'étape 402.

Dans une étape 408 suivante, le compteur électrique polyphasé 110 détermine l'indice R, tel que précédemment défini en relation avec la Fig. 3.

Dans une étape 409 suivante, le compteur électrique polyphasé 110 compare l'indice R calculé (à l'étape 408) avec un cinquième seuil Th_R_low2 et un sixième seuil Th_R_high2. Le cinquième seuil Th_R_low2 est défini à partir du premier seuil Th_R_low par application d'une certaine marge $\varepsilon'_{Rl}$, de telle sorte que :

$$\text{Th\_R\_low2} < \text{Th\_R\_low}$$

Le sixième seuil Th_R_high2 est défini à partir du second seuil Th_R_high par application d'une certaine marge $\varepsilon'_{Rh}$, de telle sorte que :

$$\text{Th\_R\_high2} > \text{Th\_R\_high}$$

Par exemple, en reprenant l'exemple précédemment détaillé, le cinquième seuil Th_R_low2 prend la valeur « 2,14 » (en considérant que le premier seuil Th_R_low a la valeur «2,40 ») et le sixième seuil Th_R_high2 prend la valeur « 5,75 » (en considérant que le second seuil Th_R_high a la valeur « 5,25 »).

En outre, dans l'étape 409, le compteur électrique polyphasé 110 compare la valeur des tensions efficaces $V_2$ et $V_3$ mesurées (à l'étape 407) avec un septième seuil Th_V_low2 et un huitième seuil Th_V_high2. Le septième seuil Th_V_low2 est défini à partir du troisième seuil Th_V_low par application d'une certaine marge $\varepsilon'_{Vl}$, de telle sorte que :

$$\text{Th\_V\_low2} < \text{Th\_V\_low}$$

Le sixième seuil Th_R_high2 est défini à partir du second seuil Th_R_high par application d'une certaine marge $\varepsilon'_{Vh}$, de telle sorte que :

$$Th\_V\_high2 > Th\_V\_high$$

Cette définition des cinquième Th_R_low2, sixième Th_R_high2, septième Th_V_low2 et huitième Th_V_high2 seuils en complément des premier Th_R_low, second Th_R_high, troisième Th_V_low et quatrième Th_V_high seuils permet de mettre en oeuvre le mécanisme d'hystérésis, afin d'éviter des instabilités dans la configuration des paramètres de calibration des opérations de comptage.

Dans une étape 410 suivante, le compteur électrique polyphasé 110 considère que la connexion au fil de neutre 104 est correctement établie, lorsque les comparaisons effectuées à l'étape 409 montrent que l'une au moins des conditions suivantes est remplie :

$$\begin{cases} Condition\ A: (R < Th\_R\_low2 \quad ou \quad R > Th\_R\_high2\,) \\ Condition\ B: (V_2 < Th\_V\_low2 \quad ou \quad V_2 > Th\_V\_high2) \\ Condition\ C: (V_3 < Th\_V\_low2 \quad ou \quad V_3 > Th\_V\_high2) \end{cases}$$

Dans le cas où le compteur électrique polyphasé 110 considère qu'il y a toujours absence de connexion au fil de neutre 104, l'étape 407 est réitérée et le comptage d'énergie électrique se poursuit avec le second jeu de paramètres de calibration ; sinon, l'étape 401 est réitérée et le comptage d'énergie électrique se poursuit avec le premier jeu de paramètres de calibration.

Les données chiffrées pour la définition des seuils utilisés dans le cadre de la présente invention sont illustratives. D'autres valeurs peuvent être utilisées, en fonction des valeurs de tension efficace fournie sur chaque phase par le réseau d'alimentation électrique et des valeurs des capacités d'impédance entre chaque phase et le neutre. Selon un autre exemple, dans le cas d'une alimentation triphasée à 110 V avec une tolérance de précision égale à ± 10 % : le premier seuil Th_R_low est fixé à la valeur « 2,40 », le second seuil Th_R_high est fixé à la valeur « 5,25 », le troisième seuil Th_V_low est fixé à 129,6 V, le quatrième seuil Th_V_high est fixé à 180,6 V, le cinquième seuil Th_R_low2 est fixé à la valeur « 2,14 », le sixième seuil Th_R_high2 est fixé à la valeur « 5,75 », le septième seuil Th_V_low2 est fixé à 119 V et le huitième seuil Th_V_high2 est fixé à 188 V. Les marges $\varepsilon_{Rl}$ et $\varepsilon_{Rh}$ peuvent être respectivement appliquées dans la définition des premier Th_R_low et second Th_R_high seuils et/ou les marges $\varepsilon_{Vl}$ et $\varepsilon_{Vh}$ peuvent être respectivement appliquées dans la définition des troisième Th_V_low et quatrième Th_V_high seuils, les autres seuils étant ici encore définis par application des marges respectives $\varepsilon'_{Rl}$, $\varepsilon'_{Rh}$, $\varepsilon'_{Vl}$ et $\varepsilon'_{Vh}$. Selon encore un autre exemple, dans le cas d'une alimentation triphasée pouvant être de 110 V ou de 230 V avec une tolérance de précision égale à ± 10 % : le premier seuil Th_R_low est fixé à la valeur «2,40 », le second seuil Th_R_high est fixé à la valeur « 5,25 », le troisième seuil Th_V_low est fixé à 129,6 V, le quatrième seuil Th_V_high est fixé à 377,7 V, le cinquième seuil Th_R_low2 est fixé à la valeur « 2,14 », le sixième seuil Th_R_high2 est fixé à la valeur «5,75 », le septième seuil Th_V_low2 est fixé à 119 V et le huitième seuil Th_V_high2 est fixé à 393 V. Les marges $\varepsilon_{Rl}$ et $\varepsilon_{Rh}$ peuvent être respectivement appliquées dans la définition des premier Th_R_low et second Th_R_high seuils et/ou les marges $\varepsilon_{Vl}$ et $\varepsilon_{Vh}$ peuvent être respectivement appliquées dans la définition des troisième Th_V_low et quatrième Th_V_high seuils, les autres seuils étant ici encore définis par application des marges respectives $\varepsilon'_{Rl}$, $\varepsilon'_{Rh}$, $\varepsilon'_{Vl}$ et $\varepsilon'_{Vh}$.

**Revendications**

1. Procédé de détection d'absence de connexion d'un compteur électrique polyphasé (110) à un neutre d'un réseau d'alimentation électrique (100), le compteur électrique polyphasé étant connecté à une pluralité de phases du réseau d'alimentation électrique, le compteur électrique polyphasé injectant dans le réseau d'alimentation électrique des signaux par courants porteurs en ligne via une phase d'injection parmi ladite pluralité, une impédance de capacité ($C_1$, $C_2$, $C_3$) prédéfinie existant entre chaque phase et le neutre, **caractérisé en ce que** le compteur électrique polyphasé effectue les étapes suivantes :

   - obtenir (301 ; 402) des mesures de tension efficace entre chaque phase et un point de connexion destiné à connecter le compteur électrique polyphasé au neutre ;
   - calculer (302 ; 403) un indice R représentatif d'un rapport entre la tension efficace mesurée pour la phase d'injection et une somme des tensions efficaces mesurées pour les autres phases de ladite pluralité;
   - comparer (303 ; 404) l'indice R avec des premier et second seuils, le premier seuil étant défini sur la base de la valeur minimale théorique de l'indice R et le second seuil étant défini sur la base de la valeur maximale théorique de l'indice R, au vu de tolérances de précision desdites capacités d'impédance et de tolérances de précision de tensions efficaces fournies par le réseau d'alimentation électrique via lesdites phases, lorsque le compteur électrique polyphasé n'est pas connecté au neutre ;

- comparer (303 ; 404) la valeur de tension efficace mesurée sur chaque phase autre que la phase d'injection avec des troisième et quatrième seuils, le troisième seuil étant défini sur la base de la valeur minimale théorique de tension efficace et le quatrième seuil étant défini sur la base de la valeur maximale théorique de tension efficace, au vu desdites tolérances de précision, lorsque le compteur électrique polyphasé n'est pas connecté au neutre ; et

- détecter (304 ; 405) que le compteur électrique n'est pas connecté au neutre lorsque les conditions suivantes sont remplies :

- l'indice R est supérieur ou égal au premier seuil et est inférieur ou égal au second seuil ; et

- la valeur de tension efficace mesurée sur chaque phase autre que la phase d'injection est supérieure ou égale au troisième seuil et est inférieure ou égale au quatrième seuil.

2. Procédé selon la revendication 1, **caractérisé en ce que** le compteur électrique polyphasé effectue une intégration de l'indice R sur une période temporelle de durée prédéfinie.

3. Procédé selon l'une quelconque des revendications 1 et 2, **caractérisé en ce que** le premier seuil est défini en considérant :

- la valeur minimale de la capacité d'impédance entre la phase d'injection et le point de connexion au neutre ;
- la valeur maximale de la capacité d'impédance entre chaque phase autre que la phase d'injection et le point de connexion au neutre ;
- la valeur maximale de la tension efficace fournie par le réseau d'alimentation électrique sur la phase d'injection ; et
- la valeur minimale de la tension efficace fournie par le réseau d'alimentation électrique sur chaque phase autre que la phase d'injection ;

et le second seuil est défini en considérant que les valeurs des tensions efficaces fournies par le réseau d'alimentation électrique sur lesdites phases sont identiques et en considérant :

- la valeur maximale de la capacité d'impédance entre la phase d'injection et le point de connexion au neutre ; et
- la valeur minimale de la capacité d'impédance entre chaque phase autre que la phase d'injection et le point de connexion au neutre.

4. Procédé selon l'une quelconque des revendications 1 à 3, **caractérisé en ce que** le troisième seuil est défini en considérant :

- la valeur minimale de la capacité d'impédance entre la phase d'injection et le point de connexion au neutre ;
- la valeur maximale de la capacité de l'impédance entre chaque phase autre que la phase d'injection et le point de connexion au neutre ; et
- la valeur minimale de la tension efficace fournie par le réseau d'alimentation électrique sur chaque phase ;

et le quatrième seuil est défini en considérant :

- la valeur maximale de la capacité d'impédance entre la phase d'injection et le point de connexion au neutre ;
- la valeur minimale de la capacité d'impédance entre chaque phase autre que la phase d'injection et le point de connexion au neutre ; et
- la valeur maximale de la tension efficace fournie par le réseau d'alimentation électrique sur chaque phase.

5. Procédé selon l'une quelconque des revendications 1 à 4, **caractérisé en ce que** l'indice R est calculé de la manière suivante :

$$R = \left( \sum_{n=2}^{N} V_n \right) / ((N-1).V_1)$$

où N représente la quantité de phases auxquelles est connecté le compteur électrique polyphasé et $n$ est un index strictement positif sur les phases, la phase d'index $n = 1$ étant la phase d'injection.

6. Procédé de gestion de détection d'absence de connexion d'un compteur électrique polyphasé (110) à un neutre d'un réseau d'alimentation électrique (100) alimentant une installation électrique pour laquelle le compteur électrique polyphasé doit effectuer des opérations de comptage d'énergie consommée, **caractérisé en ce que** le compteur électrique polyphasé met en oeuvre le procédé de détection d'absence de connexion du compteur électrique polyphasé au neutre du réseau d'alimentation électrique selon l'une quelconque des revendications 1 à 5, et **en ce que** le compteur électrique polyphasé applique (401, 406) des paramètres de calibration des opérations de comptage différents en fonction de la détection ou non d'absence de connexion du compteur électrique polyphasé au neutre du réseau d'alimentation électrique.

7. Procédé selon la revendication 6, **caractérisé en ce que** le compteur électrique polyphasé applique (401) un premier jeu de paramètres de calibration des opérations de comptage lorsque le compteur électrique polyphasé a détecté être correctement connecté au neutre du réseau d'alimentation électrique, et **en ce que** le compteur électrique polyphasé applique (406) un second jeu de paramètres de calibration des opérations de comptage lorsque le compteur électrique polyphasé a détecté une absence de connexion d'un compteur électrique polyphasé au neutre du réseau d'alimentation électrique, lesdits premier et second jeux de paramètres étant prédéfinis.

8. Procédé selon la revendication 7, **caractérisé en ce que** le compteur électrique polyphasé, pour détecter une connexion correcte du compteur électrique polyphasé au neutre, effectue les étapes suivantes :

   - comparer (409) l'indice R avec des cinquième et sixième seuils, le cinquième seuil étant défini en appliquant une marge audit premier seuil de sorte que le cinquième seuil est strictement inférieur audit premier seuil, le sixième seuil étant défini en appliquant une marge audit second seuil de sorte que le sixième seuil est strictement supérieur audit second seuil ;
   - comparer (409) la valeur de tension efficace mesurée sur chaque phase autre que la phase d'injection avec des septième et huitième seuils, le septième seuil étant défini en appliquant une marge audit troisième seuil de sorte que le septième seuil est strictement inférieur audit troisième seuil, le huitième seuil étant défini en appliquant une marge audit quatrième seuil de sorte que le huitième seuil est strictement supérieur audit quatrième seuil ;
   - détecter (410) que le compteur électrique est correctement connecté au neutre lorsque l'une au moins des conditions suivantes est remplie :

      - l'indice R est strictement inférieur au cinquième seuil ou strictement supérieur au sixième seuil ; et
      - la valeur de tension efficace mesurée sur au moins une des phases auxquelles est connecté le compteur électrique polyphasé autre que la phase d'injection est strictement inférieure au septième seuil ou strictement supérieure au huitième seuil.

9. Programme d'ordinateur, **caractérisé en ce qu'**il comprend des instructions pour mettre en oeuvre, par un compteur électrique polyphasé, le procédé selon l'une quelconque des revendications 1 à 5 ou l'une quelconque des revendications 6 à 8, lorsque ledit programme est exécuté par un processeur dudit compteur électrique polyphasé.

10. Moyens de stockage, **caractérisés en ce qu'**ils stockent un programme d'ordinateur comprenant des instructions pour mettre en oeuvre, par un compteur électrique, le procédé selon l'une quelconque des revendications 1 à 5 ou l'une quelconque des revendications 6 à 8, lorsque ledit programme est exécuté par un processeur dudit compteur électrique polyphasé.

11. Compteur électrique polyphasé (110) adapté pour détecter une absence de connexion du compteur électrique polyphasé à un neutre d'un réseau d'alimentation électrique (100), le compteur électrique polyphasé étant destiné à être connecté à une pluralité de phases du réseau d'alimentation électrique, le compteur électrique polyphasé étant adapté pour injecter dans le réseau d'alimentation électrique des signaux par courants porteurs en ligne via une phase d'injection parmi ladite pluralité, une impédance de capacité prédéfinie ($C_1$, $C_2$, $C_3$) existant entre chaque phase et le neutre, **caractérisé en ce que** le compteur électrique polyphasé comporte :

   - des moyens pour obtenir (301 ; 402) des mesures de tension efficace entre chaque phase et un point de connexion destiné à connecter le compteur électrique polyphasé au neutre ;
   - des moyens pour calculer (302 ; 403) un indice R représentatif d'un rapport entre la tension efficace mesurée pour la phase d'injection et une somme des tensions efficaces mesurées pour les autres phases de ladite pluralité ;

- des moyens pour comparer (303 ; 404) l'indice R avec des premier et second seuils, le premier seuil étant défini sur la base de la valeur minimale théorique de l'indice R et le second seuil étant défini sur la base de la valeur maximale théorique de l'indice R, au vu de tolérances de précision desdites capacités d'impédance et de tolérances de précision de tensions efficaces fournies par le réseau d'alimentation électrique via lesdites phases, lorsque le compteur électrique polyphasé n'est pas connecté au neutre ;

- des moyens pour comparer (303 ; 404) la valeur de tension efficace mesurée sur chaque phase autre que la phase d'injection avec des troisième et quatrième seuils, le troisième seuil étant défini sur la base de la valeur minimale théorique de tension efficace et le quatrième seuil étant défini sur la base de la valeur maximale théorique de tension efficace, au vu desdites tolérances de précision, lorsque le compteur électrique polyphasé n'est pas connecté au neutre ; et

- des moyens pour détecter (304 ; 405) que le compteur électrique n'est pas connecté au neutre lorsque les conditions suivantes sont remplies :

- l'indice R est supérieur ou égal au premier seuil et est inférieur ou égal au second seuil ; et
- la valeur de tension efficace mesurée sur chaque phase autre que la phase d'injection est supérieure ou égale au troisième seuil et est inférieure ou égale au quatrième seuil.

**Patentansprüche**

1. Verfahren zur Erkennung der Abwesenheit einer Verbindung zwischen einem mehrphasigen elektrischen Zähler (110) und einem Nullleiter eines elektrischen Versorgungsnetzes (100), wobei der mehrphasige elektrische Zähler mit einer Mehrzahl von Phasen des elektrischen Versorgungsnetzes verbunden ist, wobei der mehrphasige elektrische Zähler in das elektrische Versorgungsnetz Signale durch Trägerstromübertragung über eine Leitung über eine Einspeisungsphase unter der Mehrzahl einspeist, wobei eine vordefinierte Kapazitätsimpedanz ($C_1$, $C_2$, $C_3$) zwischen jeder Phase und dem Nullleiter besteht,
**dadurch gekennzeichnet, dass** der mehrphasige elektrische Zähler die folgenden Schritte durchführt:

- Vornehmen (301; 402) von Messungen der Effektivspannung zwischen jeder Phase und einem Verbindungspunkt, der dazu bestimmt ist, den mehrphasigen elektrischen Zähler mit dem Nullleiter zu verbinden;
- Berechnen (302; 403) eines Indexes R, der für ein Verhältnis zwischen der für die Einspeisungsphase gemessenen Effektivspannung und einer Summe von Effektivspannungen, die für die anderen Phasen der Mehrzahl gemessen werden, repräsentativ ist;
- Vergleichen (303; 404) des Indexes R mit einer ersten und zweiten Schwelle, wobei die erste Schwelle auf der Basis des theoretischen Minimalwerts des Indexes R definiert wird, und die zweite Schwelle auf der Basis des theoretischen Maximalwerts des Indexes R definiert wird, angesichts von Präzisionstoleranzen der Impedanzkapazitäten und von Präzisionstoleranzen der Effektivspannungen, die von dem elektrischen Versorgungsnetz über die Phasen geliefert werden, wenn der mehrphasige elektrische Zähler nicht mit dem Nullleiter verbunden ist;
- Vergleichen (303; 404) des Werts der Effektivspannung, der in jeder anderen Phase als der Einspeisungsphase gemessen wird, mit einer dritten und vierten Schwelle, wobei die dritte Schwelle auf der Basis des theoretischen Minimalwerts der Effektivspannung definiert wird, und die vierte Schwelle auf der Basis des theoretischen Maximalwerts der Effektivspannung definiert wird, angesichts der Präzisionstoleranzen, wenn der mehrphasige elektrische Zähler nicht mit dem Nullleiter verbunden ist; und
- Erkennen (304; 405), dass der elektrische Zähler nicht mit dem Nullleiter verbunden ist, wenn die folgenden Bedingungen erfüllt werden:

- der Index R ist größer oder gleich der ersten Schwelle und ist kleiner oder gleich der zweiten Schwelle; und
- der Wert der Effektivspannung, der in jeder anderen Phase als der Einspeisungsphase gemessen wird, ist größer oder gleich der dritten Schwelle und ist kleiner oder gleich der vierten Schwelle.

2. Verfahren nach Anspruch 1,
**dadurch gekennzeichnet, dass** der mehrphasige elektrische Zähler eine Integration des Indexes R in einer Zeitperiode mit vordefinierter Dauer durchführt.

3. Verfahren nach einem der Ansprüche 1 und 2,

**dadurch gekennzeichnet, dass** die erste Schwelle definiert wird, indem berücksichtigt werden:

- der Minimalwert der Impedanzkapazität zwischen der Einspeisungsphase und dem Verbindungspunkt mit dem Nullleiter;
- der Maximalwert der Impedanzkapazität zwischen jeder anderen Phase als der Einspeisungsphase und dem Verbindungspunkt mit dem Nullleiter;
- der Maximalwert der Effektivspannung, der von dem elektrischen Versorgungsnetz in der Einspeisungsphase geliefert wird; und
- der Minimalwert der Effektivspannung, der von dem elektrischen Versorgungsnetz in jeder anderen Phase als der Einspeisungsphase geliefert wird;

und die zweite Schwelle definiert wird, indem berücksichtigt wird, dass die Werte der Effektivspannungen, die von dem elektrischen Versorgungsnetz in den Phasen geliefert werden, identisch sind, und indem berücksichtigt werden:

- der Maximalwert der Impedanzkapazität zwischen der Einspeisungsphase und dem Verbindungspunkt mit dem Nullleiter; und
- der Minimalwert der Impedanzkapazität zwischen jeder anderen Phase als der Einspeisungsphase und dem Verbindungspunkt mit dem Nullleiter.

4. Verfahren nach einem der Ansprüche 1 bis 3,
**dadurch gekennzeichnet, dass** die dritte Schwelle definiert wird, indem berücksichtigt werden:

- der Minimalwert der Impedanzkapazität zwischen der Einspeisungsphase und dem Verbindungspunkt mit dem Nullleiter;
- der Maximalwert der Impedanzkapazität zwischen jeder anderen Phase als der Einspeisungsphase und dem Verbindungspunkt mit dem Nullleiter; und
- der Minimalwert der Effektivspannung, der von dem elektrischen Versorgungsnetz in jeder Phase geliefert wird;

und die vierte Schwelle definiert wird, indem berücksichtigt werden:

- der Maximalwert der Impedanzkapazität zwischen der Einspeisungsphase und dem Verbindungspunkt mit dem Nullleiter;
- der Minimalwert der Impedanzkapazität zwischen jeder anderen Phase als der Einspeisungsphase und dem Verbindungspunkt mit dem Nullleiter; und
- der Maximalwert der Effektivspannung, der von dem elektrischen Versorgungsnetz in jeder Phase geliefert wird.

5. Verfahren nach einem der Ansprüche 1 bis 4,
**dadurch gekennzeichnet, dass** der Index R auf folgende Weise berechnet wird:

$$R = \left(\sum_{n=2}^{N} V_n\right) / ((N-1).V_1)$$

wobei N die Menge der Phasen darstellt, mit denen der mehrphasige elektrische Zähler verbunden ist, und *n* ein strikt positiver Index in den Phasen ist, wobei die Phase mit dem Index *n* = 1 die Einspeisungsphase ist.

6. Verfahren zur Steuerung der Erkennung der Abwesenheit einer Verbindung zwischen einem mehrphasigen elektrischen Zähler (110) und einem Nullleiter eines elektrischen Versorgungsnetzes (100), das eine elektrische Anlage versorgt, für die der mehrphasige elektrische Zähler Vorgänge des Zählens der verbrauchten Energie durchzuführen hat,
**dadurch gekennzeichnet, dass** der mehrphasige elektrische Zähler das Verfahren zur Erkennung der Abwesenheit der Verbindung des mehrphasigen elektrischen Zählers mit dem Nullleiter des elektrischen Versorgungsnetzes nach einem der Ansprüche 1 bis 5 durchführt, und dass der mehrphasige elektrische Zähler (401, 406) unterschiedliche Parameter zur Kalibrierung der Zählvorgänge in Abhängigkeit von der Erkennung oder nicht der Abwesenheit der Verbindung des mehrphasigen elektrischen Zählers mit dem Nullleiter des elektrischen Versorgungsnetzes verwendet.

**7.** Verfahren nach Anspruch 6,
**dadurch gekennzeichnet, dass** der mehrphasige elektrische Zähler (401) einen ersten Satz von Parametern zur Kalibrierung von Zählvorgängen verwendet, wenn der mehrphasige elektrische Zähler erkannt hat, korrekt mit dem Nullleiter des elektrischen Versorgungsnetzes verbunden zu sein, und dass der mehrphasige elektrische Zähler (406) einen zweiten Satz von Parametern zur Kalibrierung von Zählvorgängen verwendet, wenn der mehrphasige elektrische Zähler eine Abwesenheit der Verbindung eines mehrphasigen elektrischen Zählers mit dem Nullleiter des elektrischen Versorgungsnetzes erkannt hat, wobei der erste und zweite Satz von Parametern vordefiniert werden.

**8.** Verfahren nach Anspruch 7,
**dadurch gekennzeichnet, dass** der mehrphasige elektrische Zähler, zur Erkennung einer korrekten Verbindung des mehrphasigen elektrischen Zählers mit dem Nullleiter, die folgenden Schritte durchführt:

- Vergleichen (409) des Indexes R mit einer fünften und sechsten Schwelle, wobei die fünfte Schwelle definiert wird, indem eine Marge auf die erste Schwelle derart angewendet wird, dass die fünfte Schwelle strikt kleiner ist als die erste Schwelle, wobei die sechste Schwelle definiert wird, indem eine Marge auf die zweite Schwelle derart angewendet wird, dass die sechste Schwelle strikt größer ist als die zweite Schwelle;
- Vergleichen (409) des Werts der Effektivspannung, der in jeder anderen Phase als der Einspeisungsphase gemessen wird, mit einer siebenten und achten Schwelle, wobei die siebente Schwelle definiert wird, indem eine Marge auf die dritte Schwelle derart angewendet wird, dass die siebente strikt kleiner ist als die dritte Schwelle, wobei die achte Schwelle definiert wird, indem eine Marge auf die vierte Schwelle derart angewendet wird, dass die achte Schwelle strikt größer ist als die vierte Schwelle;
- Erkennen (410), dass der elektrische Zähler korrekt mit dem Nullleiter verbunden ist, wenn mindestens eine der folgenden Bedingungen erfüllt wird:

- der Index R ist strikt kleiner als die fünfte Schwelle oder strikt größer als die sechste Schwelle; und
- der Wert der Effektivspannung, der in mindestens einer der anderen Phasen als der Einspeisungsphase gemessen wird, mit denen der mehrphasige elektrische Zähler verbunden ist, ist strikt kleiner als die siebente Schwelle oder strikt größer als die achte Schwelle.

**9.** Rechnerprogramm,
**dadurch gekennzeichnet, dass** dieses Instruktionen zur Durchführung, durch einen mehrphasigen elektrischen Zähler, des Verfahrens nach einem der Ansprüche 1 bis 5 oder einem der Ansprüche 6 bis 8 umfasst, wenn das Programm von einem Prozessor des mehrphasigen elektrischen Zählers ausgeführt wird.

**10.** Speichermittel,
**dadurch gekennzeichnet, dass** diese ein Rechnerprogramm speichern, das Instruktionen zur Durchführung, durch einen elektrischen Zähler, des Verfahrens nach einem der Ansprüche 1 bis 5 oder einem der Ansprüche 6 bis 8 umfasst, wenn das Programm von einem Prozessor des mehrphasigen elektrischen Zählers ausgeführt wird.

**11.** Mehrphasiger elektrischer Zähler (110), welcher eingerichtet ist, eine Abwesenheit einer Verbindung zwischen dem mehrphasigen elektrischen Zähler und einem Nullleiter eines elektrischen Versorgungsnetzes (100) zu erkennen, wobei der mehrphasige elektrische Zähler dazu bestimmt ist, mit einer Mehrzahl von Phasen des elektrischen Versorgungsnetzes verbunden zu sein, wobei der mehrphasige elektrische Zähler eingerichtet ist, in das elektrische Versorgungsnetz Signale durch Trägerstromübertragung über eine Leitung über eine Einspeisungsphase unter der Mehrzahl einzuspeisen, wobei eine vordefinierte Kapazitätsimpedanz ($C_1$, $C_2$, $C_3$) zwischen jeder Phase und dem Nullleiter besteht,
**dadurch gekennzeichnet, dass** der mehrphasige elektrische Zähler umfasst:

- Mittel zum Vornehmen (301; 402) von Messungen der Effektivspannung zwischen jeder Phase und einem Verbindungspunkt, der dazu bestimmt ist, den mehrphasigen elektrischen Zähler mit dem Nullleiter zu verbinden;
- Mittel zum Berechnen (302; 403) eines Indexes R, der für ein Verhältnis zwischen der für die Einspeisungsphase gemessenen Effektivspannung und einer Summe von Effektivspannungen, die für die anderen Phasen der Mehrzahl gemessen werden, repräsentativ ist;
- Mittel zum Vergleichen (303; 404) des Indexes R mit einer ersten und zweiten Schwelle, wobei die erste Schwelle auf der Basis des theoretischen Minimalwerts des Indexes R definiert ist, und die zweite Schwelle auf der Basis des theoretischen Maximalwerts des Indexes R definiert ist, angesichts von Präzisionstoleranzen der Impedanzkapazitäten und von Präzisionstoleranzen der Effektivspannungen, die von dem elektrischen Versorgungsnetz über die Phasen geliefert werden, wenn der mehrphasige elektrische Zähler nicht mit dem Nullleiter verbunden ist;

- Mittel zum Vergleichen (303; 404) des Werts der Effektivspannung, der in jeder anderen Phase als der Einspeisungsphase gemessen wird, mit einer dritten und vierten Schwelle, wobei die dritte Schwelle auf der Basis des theoretischen Minimalwerts der Effektivspannung definiert ist, und die vierte Schwelle auf der Basis des theoretischen Maximalwerts der Effektivspannung definiert ist, angesichts der Präzisionstoleranzen, wenn der mehrphasige elektrische Zähler nicht mit dem Nullleiter verbunden ist; und

- Mittel zum Erkennen (304; 405), dass der elektrische Zähler nicht mit dem Nullleiter verbunden ist, wenn die folgenden Bedingungen erfüllt sind:

- der Index R ist größer oder gleich der ersten Schwelle und ist kleiner oder gleich der zweiten Schwelle; und
- der Wert der Effektivspannung, der in jeder anderen Phase als der Einspeisungsphase gemessen wird, ist größer oder gleich der dritten Schwelle und ist kleiner oder gleich der vierten Schwelle.

**Claims**

1.  Method for detecting an absence of connection of a polyphase electric meter (110) to a neutral of an electrical power supply network (100), the polyphase electric meter being connected to a plurality of phases of the electrical power supply network, the polyphase electric meter injecting signals into the electrical power supply network by means of powerline communication via one injection phase from among said plurality, an impedance of predefined capacitance ($C_1$, $C_2$, $C_3$) existing between each phase and the neutral, **characterized in that** the polyphase electric meter carries out the following steps:

    - obtaining (301; 402) measurements of RMS voltage between each phase and a connection point intended to connect the polyphase electric meter to the neutral;
    - calculating (302; 403) an index R representative of a ratio between the RMS voltage measured for the injection phase and a sum of RMS voltages measured for the other phases of said plurality;
    - comparing (303; 404) the index R with first and second thresholds, the first threshold being defined on the basis of the theoretical minimum value of the index R and the second threshold being defined on the basis of the theoretical maximum value of the index R, taking into consideration precision tolerances of said impedance capacitances and precision tolerances of RMS voltages delivered by the electrical power supply network via said phases, when the polyphase electric meter is not connected to the neutral;
    - comparing (303; 404) the RMS voltage value measured on each phase other than the injection phase with third and fourth thresholds, the third threshold being defined on the basis of the theoretical minimum RMS voltage value and the fourth threshold being defined on the basis of the theoretical maximum RMS voltage value, taking into consideration said precision tolerances, when the polyphase electric meter is not connected to the neutral; and
    - detecting (304; 405) that the electric meter is not connected to the neutral when the following conditions are met:

        - the index R is higher than or equal to the first threshold and is lower than or equal to the second threshold; and
        - the RMS voltage value measured on each phase other than the injection phase is higher than or equal to the third threshold and is smaller than or equal to the fourth threshold.

2.  Method according to Claim 1, **characterized in that** the polyphase electric meter integrates the index R over a time period of predefined duration.

3.  Method according to either of Claims 1 and 2, **characterized in that** the first threshold is defined by considering:

    - the minimum value of the impedance capacitance between the injection phase and the point of connection to the neutral;
    - the maximum value of the impedance capacitance between each phase other than the injection phase and the point of connection to the neutral;
    - the maximum value of the RMS voltage delivered by the electrical power supply network on the injection phase; and
    - the minimum value of the RMS voltage delivered by the electrical power supply network on each phase other than the injection phase;

and the second threshold is defined by considering the RMS voltage values delivered by the electrical power supply network on said phases to be identical and by considering:

- the maximum value of the impedance capacitance between the injection phase and the point of connection to the neutral; and
- the minimum value of the impedance capacitance between each phase other than the injection phase and the point of connection to the neutral.

4.  Method according to any one of Claims 1 to 3, **characterized in that** the third threshold is defined by considering:

- the minimum value of the impedance capacitance between the injection phase and the point of connection to the neutral;
- the maximum value of the capacitance of the impedance between each phase other than the injection phase and the point of connection to the neutral; and
- the minimum value of the RMS voltage delivered by the electrical power supply network on each phase;

and the fourth threshold is defined by considering:

- the maximum value of the impedance capacitance between the injection phase and the point of connection to the neutral;
- the minimum value of the impedance capacitance between each phase other than the injection phase and the point of connection to the neutral; and
- the maximum value of the RMS voltage delivered by the electrical power supply network on each phase.

5.  Method according to any one of Claims 1 to 4, **characterized in that** the index R is calculated as follows:

$$R = \left(\sum_{n=2}^{N} V_n\right) / ((N-1).V_1)$$

where N is the quantity of phases to which the polyphase electric meter is connected and $n$ is a strictly positive index on the phases, the phase of index $n = 1$ being the injection phase.

6.  Method for managing the detection of an absence of connection of a polyphase electric meter (110) to a neutral of an electrical power supply network (100) supplying power to an electrical installation for which the polyphase electric meter must meter the energy consumed, **characterized in that** the polyphase electric meter implements the method for detecting an absence of connection of the polyphase electric meter to the neutral of the electrical power supply network according to any one of Claims 1 to 5, and **in that** the polyphase electric meter applies (401, 406) different metering operation calibration parameters depending on whether or not an absence of connection of the polyphase electric meter to the neutral of the electrical power supply network is detected.

7.  Method according to Claim 6, **characterized in that** the polyphase electric meter applies (401) a first set of metering operation calibration parameters when the polyphase electric meter has detected that it is correctly connected to the neutral of the electrical power supply network, and **in that** the polyphase electric meter applies (406) a second set of metering operation calibration parameters when the polyphase electric meter has detected an absence of connection of a polyphase electric meter to the neutral of the electrical power supply network, said first and second sets of parameters being predefined.

8.  Method according to Claim 7, **characterized in that**, in order to detect that the polyphase electric meter is correctly connected to the neutral, the polyphase electric meter carried out the following steps:

- comparing (409) the index R with fifth and sixth thresholds, the fifth threshold being defined by applying a margin to said first threshold such that the fifth threshold is strictly lower than the first threshold, the sixth threshold being defined by applying a margin to said second threshold such that the sixth threshold is strictly higher than said second threshold;
- comparing (409) the RMS voltage value measured on each phase other than the injection phase with seventh

19

and eighth thresholds, the seventh threshold being defined by applying a margin to said third threshold such that the seventh threshold is strictly lower than said third threshold, the eighth threshold being defined by applying a margin to said fourth threshold such that the eighth threshold is strictly higher than said fourth threshold;
- detecting (410) that the electric meter is correctly connected to the neutral when at least one of the following conditions is met:

- the index R is strictly lower than the fifth threshold or strictly higher than the sixth threshold; and
- the RMS voltage value measured on at least one of the phases, other than the injection phase, to which the polyphase electric meter is connected is strictly lower than the seventh threshold or strictly higher than the eighth threshold.

9. Computer program, **characterized in that** it comprises instructions for implementing, by means of a polyphase electric meter, the method according to any one of Claims 1 to 5 or any one of Claims 6 to 8, when said program is executed by a processor of said polyphase electric meter.

10. Storage means, **characterized in that** they store a computer program comprising instructions for implementing, by means of an electric meter, the method according to any one of Claims 1 to 5 or any one of Claims 6 to 8, when said program is executed by a processor of said polyphase electric meter.

11. Polyphase electric meter (110) suitable for detecting an absence of connection of the polyphase electric meter to a neutral of an electrical power supply network (100), the polyphase electric meter being intended to be connected to a plurality of phases of the electrical power supply network, the polyphase electric meter being suitable for injecting signals into the electrical power supply network by means of powerline communication via one injection phase from among said plurality, an impedance of predefined capacitance ($C_1$, $C_2$, $C_3$) existing between each phase and the neutral, **characterized in that** the polyphase electric meter includes:

- means for obtaining (301; 402) measurements of RMS voltage between each phase and a connection point intended to connect the polyphase electric meter to the neutral;
- means for calculating (302; 403) an index R representative of a ratio between the RMS voltage measured for the injection phase and a sum of RMS voltages measured for the other phases of said plurality;
- means for comparing (303; 404) the index R with first and second thresholds, the first threshold being defined on the basis of the theoretical minimum value of the index R and the second threshold being defined on the basis of the theoretical maximum value of the index R, taking into consideration precision tolerances of said impedance capacitances and precision tolerances of RMS voltages delivered by the electrical power supply network via said phases, when the polyphase electric meter is not connected to the neutral;
- means for comparing (303; 404) the RMS voltage value measured on each phase other than the injection phase with third and fourth thresholds, the third threshold being defined on the basis of the theoretical minimum RMS voltage value and the fourth threshold being defined on the basis of the theoretical maximum RMS voltage value, taking into consideration said precision tolerances, when the polyphase electric meter is not connected to the neutral; and
- means for detecting (304; 405) that the electric meter is not connected to the neutral when the following conditions are met:

- the index R is higher than or equal to the first threshold and is lower than or equal to the second threshold; and
- the RMS voltage value measured on each phase other than the injection phase is higher than or equal to the third threshold and is smaller than or equal to the fourth threshold.

Fig. 1A

Fig. 1B

110

| 200 CPU | 201 RAM | 202 ROM |

210

| 203 | 204 | 205 |

Fig. 2

Mesures de tensions efficaces V1, V2, V3  301

Détermination d'un indice R dépendant des tensions efficaces V1, V2, V3  302

Comparaison de l'indice R et des tensions efficaces V2, V3 avec des seuils prédéfinis  303

non  Détection d'absence de neutre?  oui

304

Génération d'un signal d'alarme  305

Fig. 3

EP 2 950 111 B1

```
        ┌─────────────────────────────┐
   401  │  Application d'un premier jeu de │ ◄────────┐
        │   paramètres de calibration      │          │
        └─────────────────────────────┘          │
                      │                            │
                      ▼                            │
        ┌─────────────────────────────┐  402       │
   ──►  │ Mesures de tensions efficaces V1, V2, V3 │  │
   │    └─────────────────────────────┘          │
   │                  │                           │
   │                  ▼                           │
   │    ┌─────────────────────────────┐  403      │
   │    │ Détermination d'un indice R dépendant │  │
   │    │   des tensions efficaces V1, V2, V3   │  │
   │    └─────────────────────────────┘          │
   │                  │                           │
   │                  ▼                           │
   │    ┌─────────────────────────────┐  404      │
   │    │ Comparaison de l'indice R et des tensions efficaces │ │
   │    │  V2, V3 avec des premiers seuils prédéfinis │       │
   │    └─────────────────────────────┘          │
   │                  │                           │
   │          non     ▼      oui                  │
   │    ◄─────< Détection d'absence de neutre? >──┐ │
   │              405                             │ │
   │                                              │ │
   │                  ┌───────────────────────────┘ │
   │                  ▼                             │
   │    ┌─────────────────────────────┐  406        │
   │    │  Application d'un second jeu de │           │
   │    │   paramètres de calibration      │           │
   │    └─────────────────────────────┘           │
   │                  │                            │
   │                  ▼                            │
   │    ┌─────────────────────────────┐  407       │
   ──►  │ Mesures des tensions efficaces V1, V2, V3 │  │
   │    └─────────────────────────────┘           │
   │                  │                            │
   │                  ▼                            │
   │    ┌─────────────────────────────┐  408       │
   │    │ Détermination de l'indice R dépendant │    │
   │    │  des tensions efficaces V1, V2, V3    │    │
   │    └─────────────────────────────┘           │
   │                  │                            │
   │                  ▼                            │
   │    ┌─────────────────────────────┐  409       │
   │    │ Comparaison de l'indice R et des tensions │ │
   │    │ efficaces V2, V3 avec des seuils prédéfinis │ │
   │    └─────────────────────────────┘           │
   │                  │                            │
   │          non     ▼      oui                   │
   └─────< Détection présence de neutre? >─────────┘
                  410
```

Fig. 4

**EP 2 950 111 B1**

**RÉFÉRENCES CITÉES DANS LA DESCRIPTION**

**Documents brevets cités dans la description**

- US 6236197 B1